# EUROPÄISCHE PATENTSCHRIFT

(11) **EP 2 261 961 B1**
(45) Veröffentlichungstag und Bekanntmachung des Hinweises auf die Patenterteilung: **17.07.2019**
(21) Anmeldenummer: 10009591.8
(22) Anmeldetag: 03.03.2000
(51) Int. Cl.: H01L 21/336, H01L 29/10, H01L 29/78, H01L 29/739, H01L 21/225

(54) **Verfahren zur Herstellung einer vertikalen MOS-Transistoranordnung**
Method of making a vertical MOS transistor device
Méthode de fabrication d'un dispositif à transistor MOS vertical

(30) Priorität: 04.03.1999 DE 19909563
(43) Veröffentlichungstag der Anmeldung: 15.12.2010
(62) Teilanmeldung aus: 00918684.2
(73) Patentinhaber: Infineon Technologies AG, 85579 Neubiberg (DE)
(72) Erfinder: Gassel, Helmut, 85609 Aschheim (DE); Hirler, Franz, 84424 Isen (DE); Kanert, Werner, 83607 Holzkirchen (DE); Pairitsch, Herbert, 9020 Klagenfurt (AT); Strack, Helmut, 80804 München (DE)
(74) Vertreter: Westphal, Mussgnug & Partner Patentanwälte mbB

(56) Entgegenhaltungen:
- EP-A1- 0 893 830
- EP-A2- 0 717 450
- WO-A1-97/07547

## Beschreibung

Die vorliegende Erfindung betrifft ein Verfahren zur Herstellung eines Bodygebietes für eine vertikale MOS-Transistoranordnung in einem Halbleiterkörper, die einen verringerten spezifischen Einschaltwiderstand aufweist. Ein wesentlicher Faktor zur Optimierung des Einschaltwiderstandes von MOS-Transistoranordnungen ist die Verkürzung der Kanallänge der MOS-Struktur. Die minimal mögliche Kanallänge und damit der minimal mögliche Kanalwiderstand ist durch die sogenannte Punchfestigkeit festgelegt. Die Ladungsträgerkonzentration im Bodygebiet zwischen Sourcegebiet und Draingebiet muß so hoch sein, daß bis zur maximal erlaubten Drain-Source-Spannung sich die Raumladungszonen an den pn-Übergängen Sourcegebiet-Bodygebiet und Bodygebiet-Draingebiet nicht berühren, da sonst ein unzulässig hoher Strom fließt. Andererseits ist jedoch durch die bei üblichen MOS-Transistoranordnungen meist vorgegebene Einsatzspannung die maximale Ladungsträgerkonzentration des Bodygebietes im Kanalbereich festgelegt.

In der WO 97/07547 A1 ist eine vertikale MOS-Transistoranordnung mit einem einen Kanalbereich umfassenden p-dotierten Bodygebiet und einem im Vergleich zum p-dotierten Bodygebiet höher dotierten tiefen p-Bodygebiet unterhalb des den Kanalbereich umfassenden p-dotierten Bodygebiets zwischen zwei grabenförmigen Gate-Elektroden gezeigt.

In der EP 0893830 A1 ist eine vertikale MOS-Transistoranordnung mit einem einen Kanalbereich umfassenden p-dotierten Bodygebiet und einem p-Bodygebiet unterhalb des den Kanalbereich umfassenden p-dotierten Bodygebiets zwischen zwei grabenförmigen Gate-Elektroden gezeigt.

In der EP 0717450 A2 ist eine vertikale MOS-Transistoranordnung mit einem einen Kanalbereich umfassenden p-dotierten Bodygebiet und einem im Vergleich zum p-dotierten Bodygebiet niedriger dotierten tiefen p-Bodygebiet unterhalb des den Kanalbereich umfassenden p-dotierten Bodygebiets zwischen zwei grabenförmigen Gate-Elektroden gezeigt.

Aufgabe der vorliegenden Erfindung ist es, ein Verfahren zur Herstellung einer vertikalen MOS-Transistoranordnung bereitzustellen, wodurch eine Verringerung der Kanallänge der Transistoranordnung bei gleichbleibender Durchbruchsspannung und damit eine Verringerung des spezifischen Einschaltwiderstandes erreicht werden kann.

Diese Aufgabe wird gelöst durch die Merkmale des vorliegenden Anspruchs 1.

Es wird ein Verfahren zur Herstellung eines Bodygebietes ersten Leitungstyps für eine vertikale MOS-Transistoranordnung in einem Halbleiterkörper beschrieben, wobei das Bodygebiet mindestens eine Kanalregion umfaßt, die zwischen einem Sourcegebiet zweiten Leitungstyps und einem Draingebiet zweiten Leitungstyps angeordnet ist und an eine Gate-Elektrode angrenzt. Das Bodygebiet und das Sourcegebiet erstrecken sich dabei von einer ersten Oberfläche eines Halbleiterkörpers aus in den Halbleiterkörper hinein, das Draingebiet erstreckt sich von einer zweiten Oberfläche des Halbleiterkörpers aus in den Halbleiterkörper hinein. Die Gate-Elektrode kann dabei beispielsweise entweder auf der ersten Oberfläche des Halbleiterkörpers angeordnet sein oder sie kann auch in einem Gate-Graben angeordnet sein, der sich in vertikaler Richtung von der ersten Oberfläche des Halbleiterkörpers aus in den Halbleiterkörper erstreckt.

Mindestens zwei Implantationen eines Dotiermaterials ersten Leitungstyps werden in den Halbleiterkörper durchgeführt. Die erste Implantation erfolgt derart, daß das Implantationsmaximum von der Kanalregion zurückgesetzt angeordnet ist. Ist also die Gate-Elektrode der Transistoranordnung im Bereich der ersten Oberfläche angeordnet, und liegt somit auch die Kanalregion im Bereich der Oberfläche, so wird die erste Implantation derart durchgeführt, daß das Implantationsmaximum von der ersten Oberfläche zurückgesetzt im Halbleiterkörper liegt. Für den Fall einer Gate-Elektrode, die in einem vertikalen Gate-Graben angeordnet ist, wird die Implantation so durchgeführt, daß das Implantationsmaximum in lateraler Richtung vom Kanalgebiet zurückgesetzt angeordnet ist, welches sich entlang der Gate-Elektrode in vertikaler Richtung im Bodygebiet erstreckt. Es kann dabei auch gleichzeitig vorgesehen sein, daß das Implantationsmaximum ebenfalls von der ersten Oberfläche zurückgesetzt innerhalb des Halbleiterkörpers angeordnet ist.

Eine zweite Implantation von Dotiermaterial ersten Leitungstyps wird so durchgeführt, daß das Implantationsmaximum der zweiten Implantation im Halbleiterkörper unterhalb des Implantationsmaximums der ersten Implantation liegt, die Dosis der zweiten Implantation jedoch geringer ist als die Dosis der ersten Implantation. Es erfolgt eine Ausdiffusion des implantierten Dotiermaterials, wobei je nach den Gegebenheiten eine Ausdiffusion nach jeder einzelnen Implantation vorgesehen sein kann oder auch eine Ausdiffusion erst erfolgt, nachdem alle Implantationen durchgeführt wurden.

Die Vorgaben für die Implantation und Ausdiffusion des Dotiermaterials können dabei so eingestellt werden, daß im Gebiet der ersten Implantation des Dotiermaterials ein Gradient der Dotierungskonzentration in Richtung auf die Kanalregion hin erzielt werden kann. Damit kann erreicht werden, daß in der Kanalregion eine geringere Konzentration des Dotiermaterials und damit auch eine geringere Ladungsträgerkonzentration vorliegt, wodurch die Einsatzspannung der MOS-Transistoranordnung nicht wesentlich verändert wird. Andererseits wird jedoch durch die größere Konzentration des Dotiermaterials, die von der Kanalregion zurückgesetzt angeordnet wird, eine Erhöhung der Ladungsträgerkonzentration in einem Teilbereich des Bodygebietes erzielt werden, die die Punchfestigkeit der MOS-Transistoranordnung gewährleistet.

Die zweite Implantation mit geringerer Dotierungskonzentration unterhalb der ersten Implantation, also in einem Bereich des Bodygebietes, der dem Draingebiet zugewandt ist und in der Regel an eine Driftregion angrenzt, führt dazu, daß im Sperrfall der MOS-Transistoranordnung eine teilweise gegenseitige Ausräumung dieses Bereiches des Bodygebietes und der angrenzenden Driftregion des Draingebietes durch einen Kompensationseffekt erreicht werden kann. Somit kann bei der Anordnung eine Erhöhung der Durchbruchsspannung erzielt werden. Umgekehrt kann bei gleichbleibender Durchbruchsspannung die Dicke der Driftregion verringert und die Dotierung der Driftregion erhöht werden, was zu einer Verringerung des Einschaltwiderstandes führt.

Durch das erfindungsgemäße Verfahren kann somit auf einfache Weise ein optimiertes Dotierungsprofil eines Bodygebietes einer vertikalen MOS-Transistoranordnung erzeugt werden, die eine Verringerung des spezifischen Einschaltwiderstandes der MOS-Transistoranordnung erlaubt. Soweit dies wünschenswert ist, kann auch eine Erhöhung der Durchbruchsspannung erreicht werden. Aus dem Stand der Technik ist es prinzipiell beispielsweise aus US 4,809,047 A oder US 4,837,606 A bekannt, Implantationen von Dotiermaterial durchzuführen, um ein Dotierungsprofil im Bodygebiet zu erreichen. Diese Profile sind jedoch nicht dazu geeignet, in der erfindungsgemäßen Weise eine Verringerung des spezifischen Einschaltwiderstandes und eine Verbesserung der Spannungsfestigkeit der Transistoranordnung zu erreichen.

Die Dosis der ersten Implantation kann um einen Faktor im Bereich von 10 bis 1000 größer gewählt werden als die Dosis der zweiten Implantation. Speziell kann dabei die erste Implantation etwa um einen Faktor 100 größer gewählt werden als die Dosis der zweiten Implantation.

Sollte noch eine weitere Variation des Dotierungsprofils des Bodygebietes gewünscht sein, so können zusätzliche Verfahrensschritte vorgesehen werden, in denen Dotiermaterial in den Bereich des Bodygebietes eingebracht wird. So kann vorgesehen werden, daß z.B. nach einer Belegung der ersten Oberfläche mit Dotiermaterial ersten Leitungstyps in einem Diffusionsschritt das Dotiermaterial von der ersten Oberfläche aus in den Halbleiterkörper eindiffundiert wird. Damit kann beispielsweise erreicht werden, daß die Dotierungskonzentration im Bereich der Kanalregion noch genauer eingestellt werden kann, um die Einsatzspannung der Transistoranordnung noch genauer -auf einen gewünschten Wert einzustellen. Ein solcher Verfahrensschritt kann speziell dann Anwendung finden, wenn die Transistorstruktur eine grabenförmige Gate-Elektrode aufweist.

Es kann auch vorgesehen werden, daß in einem zusätzlichen Implantationsschritt Dotiermaterial ersten Leitungstyps so in den Halbleiterkörper eingebracht wird, daß das Implantationsmaximum im Bereich der Kanalregion liegt. Durch einen solchen Schritt kann gezielt die Dotierungskonzentration in der Kanalregion und damit die Einsatzspannung der Transistoranordnung beeinflußt werden. Dieses Verfahren ist insbesondere dann relativ einfach durchführbar, wenn die Gate-Elektrode und damit die Kanalregion im Bereich der ersten Oberfläche des Halbleiterkörpers liegen. Das Verfahren kann jedoch auch prinzipiell dann Anwendung finden, wenn eine grabenförmige Gate-Elektrode vorgesehen ist. Hierbei muß jedoch gegebenenfalls die laterale Ausdehnung des Implantationsgebietes weitgehend eingeschränkt werden, um störende Einflüsse auf den übrigen Bereich der Transistorstruktur, speziell des Bodygebietes zu vermeiden.

Die Dosis der dritten Implantation kann im Bereich von 10 % bis 90 % der Dosis der ersten Implantation gewählt werden, speziell im Bereich von 50 % bis 60 % der Dosis der ersten Implantation.

Spezielle Beispiele des erfindungsgemäßen Verfahrens werden nachfolgend anhand der Figuren 5 bis 6 erläutert.

Die Figuren 1 bis 4 erläutern Beispiele, die hilfreich zum Verständnis der Erfindung sind. Es zeigen:
- Figur 1:: Zweifachimplantation zur Herstellung eines Bodygebietes einer vertikalen MOS-Transistoranordnung.
- Figur 2:: Schematische Darstellung einer vertikalen MOS-Transistoranordnung, bei der ein Herstellungsschritt nach Figur 1 Anwendung fand.
- Figur 3:: Verfahrensschritt gemäß Figur 1 mit einer zusätzlichen, dritten Implantation in der Kanalregion.
- Figur 4:: Herstellungsschritt nach Figur 1 mit einer zusätzlichen Eindiffusion von Dotiermaterial im Bodygebiet.
- Figur 5:: Herstellungsschritt nach Figur 4 bei einer vertikalen MOS-Transistoranordnung mit grabenförmigen Gate-Elektroden.
- Figur 6:: Schematische Darstellung einer fertigen vertikalen MOS-Transistoranordnung, die mit einem Herstellungsschritt nach Figur 5 erzeugt wurde.

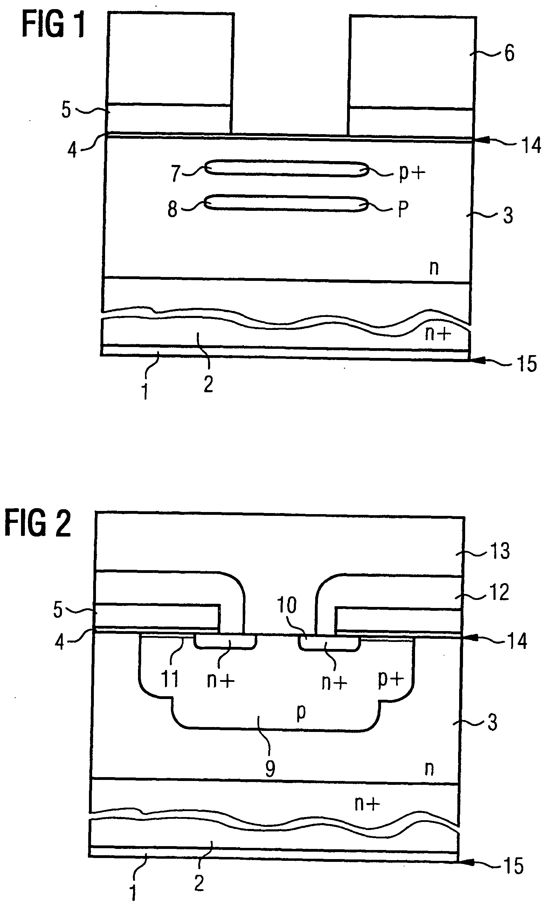

Figur 1 zeigt in einer schematischen Darstellung die Herstellung eines Bodygebietes einer vertikalen MOS-Transistoranordnung durch eine zweifache Implantation von Dotiermaterial ersten Leitungstyps, im vorliegenden Beispiel vom Typ P. Die MOS-Transistoranordnung besitzt eine erste Oberfläche 14 und eine zweite Oberfläche 15 weist eine n⁺-Drainzone 2 im Bereich der zweiten Oberfläche 15 auf. Auf diese zweite Oberfläche 15 ist eine Drain-Metallisierung 1 aufgebracht. Es kann jedoch auch vorgesehen sein, daß im Bereich dieser zweiten Oberfläche noch eine zusätzliche Anodenzone vorgesehen wird, auf die dann die entsprechende Metallisierung 1 aufgebracht wird. Solche Strukturen finden sich insbesondere bei IGBTs (Insulated Gate Bipolar Transistoren).

An die Drainzone 2 grenzt eine n-Driftzone 3 an. Diese erstreckt sich bis zu der ersten Oberfläche 14 der MOS-Transistoranordnung. Auf diese erste Oberfläche 14 ist eine Gateoxidschicht 4 aufgebracht. Auf dieser Gateoxidschicht 4 befinden sich Gate-Elektroden 5. Diese sind mit einem Fotolack 6 maskiert, der Öffnungen aufweist. Durch diese Öffnungen wird nun eine Implantation von Dotiermaterial vom Typ P vorgenommen. Es erfolgt dabei eine erste Implantation 7 mit einer höheren Dosis, die beispielsweise im Bereich von 5 x 10¹³ cm⁻² liegen kann. Wird als Dotiermaterial beispielsweise Bor verwendet, so erfolgt die Implantation mit einer Implantationsenergie von etwa 200 bis 400 keV, so daß das Implantationsmaximum in einer Tiefe von rund 500 nm liegt.
Es erfolgt weiterhin eine zweite p-Implantation 8, die jedoch nur mit einer Dosis von etwa 5 x 10¹¹ cm⁻² durchgeführt wird. Es ist hierfür für Bor eine Implantationsenergie von etwa 1 bis 2 MeV vorgesehen.
Eine Ausdiffusion dieser Implantation kann bei etwa 1100°C während einer Zeit von etwa 50 bis 100 Minuten erfolgen.

Figur 2 zeigt schematisch eine fertige MOS-Transistoranordnung, wobei das Bodygebiet 9 dieser Transistoranordnung nach einem Verfahrensschritt nach Figur 1 hergestellt werden kann. Es wird dabei deutlich, daß das Bodygebiet einen p⁺-Bereich höherer Dotierungskonzentration im Bereich unterhalb der ersten Oberfläche 14 aufweist, sowie einen p-Bereich niedrigerer Dotierungskonzentration, der sich in Richtung der Drainzone 2 erstreckt und an die Driftregion 3 angrenzt. Gerade in diesem unteren Bereich des Bodygebietes 9 kann eine gegenseitige Kompensation der p-Ladungsträger des Bodygebietes und der n-Ladungsträger der Driftregion erfolgen, so daß eine gegenseitige Ausräumung dieser Gebiete erfolgt und ein weitgehend intrinsisches Gebiet entsteht. Dieses Gebiet kann im Sperrfall einen großen Teil der Sperrspannung aufnehmen und trägt wesentlich zu einer verbesserten Spannungsfestigkeit der MOS-Transistoranordnung bei.

In Figur 2 sind weiterhin dargestellt:
Die Kanalregionen 11 im Bodygebiet 9, die zwischen den n⁺-Sourcegebieten 10 und der n-Driftzone 3 angeordnet sind. Über den Gate-Elektroden 5 ist eine weitere Oxidschicht 12 angeordnet. Durch eine Metallisierung 13 erfolgt eine Kontaktierung der n⁺-Sourcegebiete 10 und des p-Bodygebietes 9.

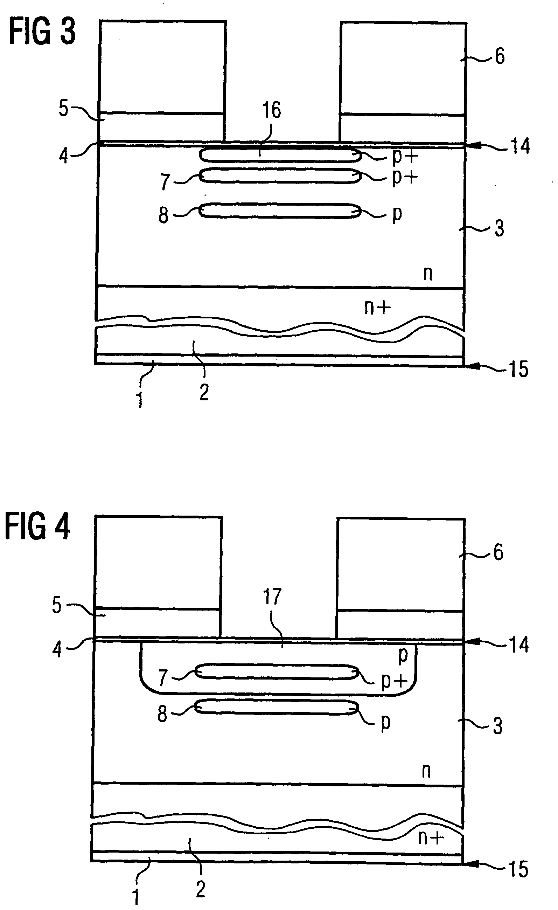

Figur 3 entspricht weitgehend dem in Figur 1 dargestellten Verfahrensschritt zur Herstellung des Bodygebietes 9. Hierbei ist jedoch im Bereich der späteren Kanalregion 11 der MOS-Transistoranordnung eine zusätzliche p⁺-Implantation 16 vorgesehen. Diese kann mit einer ähnlichen Dosis durchgeführt werden wie die erste Implantation 7. So wird beispielsweise eine Dosis von 3 x 10¹³ cm⁻² vorgesehen. Die Implantationsenergie beträgt für Bor etwa 50 keV. Das Maximum dieser zusätzlichen, dritten Implantation 16 liegt somit sehr nahe im Bereich der ersten Oberfläche 14. Diese dritte Implantation 16 wird dazu benutzt, die Dotierungskonzentration im Bereich der Kanalregion 11 der MOS-Transistoranordnung exakter einzustellen. Dies kann insbesondere dann vorgesehen werden, wenn als Dotiermaterial Bor verwendet wird. Durch eine Ausdiffusion der ersten Implantation 7 erfolgt nämlich keine Anreicherung von Bor an der Grenzfläche im Bereich der ersten Oberfläche 14. Bor zeigt vielmehr eher das gegenteilige Verhalten bezüglich seiner Segregation an Grenzflächen. Es kann somit bei Verwendung von Bor der Fall auftreten, daß durch diese Ausdiffusion eine etwas zu geringere Dotierungskonzentration im Bereich der Kanalregion erreicht wird oder diese Dotierungskonzentration nicht genau genug eingestellt werden kann. Zur genaueren Regulierung kann deshalb eine dritte Implantation hilfreich sein. Wird jedoch Phosphor als Implantationsmaterial verwendet, so kann bereits durch die erste Implantation 7 die Dotierungskonzentration im Kanalbereich 11 entsprechend eingestellt werden. Wird nämlich diese erste Implantation ausdiffundiert, so reichert sich der Phosphor im Bereich von Grenzflächen an, damit also auch im Bereich der ersten Oberfläche 14. Eine zusätzliche Implantation 16 kann damit entbehrlich sein, sie kann jedoch ebenfalls für eine exaktere Einstellung der Einsatzspannung als zusätzliche Maßnahme vorgesehen werden.

Unabhängig davon, ob nun eine dritte Implantation 16 vorgesehen wird oder nicht, kann jedoch erzielt werden, daß in einem Bereich des Bodygebietes 9, der von der Kanalregion 11 zurückgesetzt angeordnet ist, eine höhere Dotierungskonzentration erzielt wird als im Bereich der Kanalregion 11. Somit kann die Gesamtladung des Bodygebietes erhöht werden, wobei jedoch gleichzeitig die Einsatzspannung in der Kanalregion weitgehend unverändert gehalten werden kann.

Figur 4 zeigt eine Alternative zu Figur 3, wobei keine dritte Implantation 16 vorgesehen wird, sondern z.B. nach einer Belegung der Oberfläche mit Dotiermaterial ein Diffusionsschritt zur Erzeugung eines p-Diffusionsgebietes 17 im Bereich des späteren Bodygebietes 9. Damit kann bereits eine erste Hintergrunddotierung des Bodygebietes erzielt werden. Zusätzlich kann durch dieses Diffusionsgebiet 17 auch die Dotierungskonzentration in der Kanalregion 11 genauer eingestellt werden.

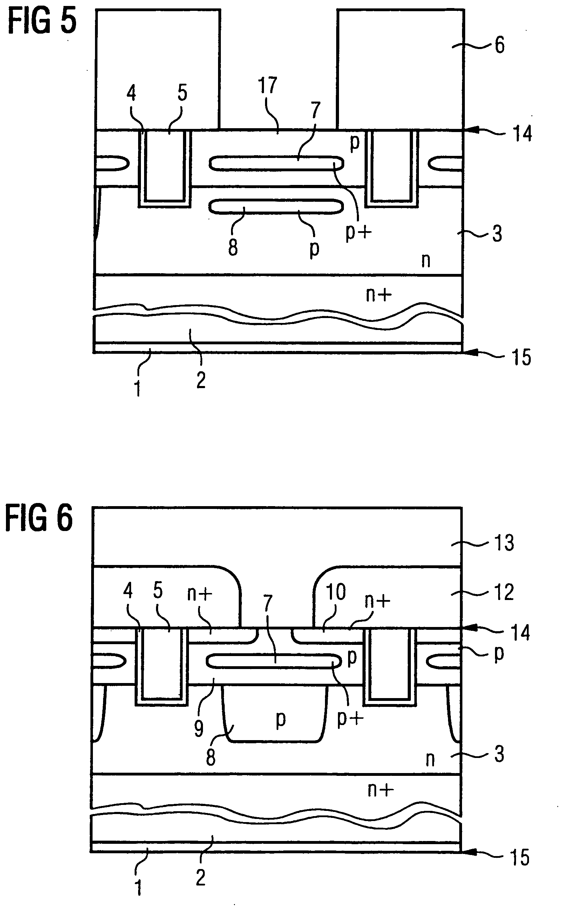

Figur 5 zeigt die Anwendung eines analogen Verfahrensschrittes zu Figur 4 bei einer MOS-Transistöranordnung, die grabenförmige Gate-Elektroden 5 aufweist. Dabei wurde bereits in einem Diffusionsschritt ein p-Diffusionsgebiet 17 zwischen den Gate-Elektroden 5 erzeugt. Anschließend erfolgt eine erste Implantation 7, deren Implantationsmaximum im Bereich des Diffusionsgebietes 17 liegt. Das Implantationsmaximum der zweiten Implantation 8 liegt unterhalb des Diffusionsgebietes 17. In einem oder mehreren weiteren Diffusionsschritten erfolgt die Ausdiffusion der Implantationen 7 und 8, so daß eine Struktur nach Figur 6 entsteht. Das fertige Bodygebiet 9 weist somit einen niedriger dotierten p-Bereich 8 auf, der sich in Richtung auf die Drainzone 2 hin erstreckt: und an die Driftregion 3 angrenzt. In diesem Bereich kann durch eine Ladungsträgerkompensation mit der Driftregion 3 und somit eine gegenseitige Ausräumung dieser Gebiete eine erhöhte Spannungsaufnahme der MOS-Transistoranordnung erzielt werden. Umgekehrt kann bei gleicher Spannungsfestigkeit die Kanallänge verringert werden. Außerdem weist das Bodygebiet 9 einen weitgehend zentralen p⁺-Bereich 7 auf, der zu einer Erhöhung der Gesamtzahl der Ladungsträger im Bodygebiet und damit zu einer erhöhten Punchfestigkeit der MOS-Transistoranordnung beiträgt. Diese wirkt sich jedoch kaum auf die Kanalregion 11 aus, so daß die Einsatzspannung nicht wesentlich beeinflußt wird.

Bei allen Anordnungen kann durch das beschriebene Verfahren also bei gleichbleibender oder sogar erhöhter Spannungsfestigkeit und Punchfestigkeit der MOS-Kanal der Transistoranordnung verkürzt und der Einschaltwiderstand damit verringert werden.

## Patentansprüche

1. Verfahren zur Herstellung eines Bodygebietes (9) ersten Leitungstyps für eine vertikale MOS-Transistoranordnung mit einer grabenförmigen Gate-Elektrode in einem vertikalen Graben in einem Halbleiterkörper, aufweisend folgende Schritte:
- Erzeugen eines Diffusionsgebiets (17) vom ersten Leitungstyp in dem Halbleiterkörper zwischen zwei der grabenförmigen Gate-Elektroden an einer ersten Oberfläche des Halbleiterkörpers,
- Erste Implantation eines Dotiermaterials des ersten Leitungstyps (7) in den Halbleiterkörper derart, dass das Implantationsmaximum im Bereich des Diffusionsgebiets (17) liegt,
- Zweite Implantation eines Dotiermaterials des ersten Leitungstyps (8) in den Halbleiterkörper derart, dass das Implantationsmaximum unterhalb des Diffusionsgebiets (17) liegt,
- Ausdiffusion des implantierten Dotiermaterials (7,8) derart, dass ein Bodygebiet (9) mit einem niedriger dotierten Bereich (8) entsteht, der sich in Richtung auf eine Drainzone (2) an einer zweiten Oberfläche (15) des Halbleiterkörpers hin erstreckt und an eine Driftregion (3) angrenzt.

2. Verfahren nach Anspruch 1,
**dadurch gekennzeichnet,**
**dass** die Dosis der ersten Implantation um einen Faktor 10 bis 1000 größer ist als die Dosis der zweiten Implantation.

3. Verfahren nach Anspruch 2,
**dadurch gekennzeichnet,**
**dass** die Dosis der ersten Implantation um einen Faktor 100 größer ist als die Dosis der zweiten Implantation.

4. Verfahren nach einem der Ansprüche 1 bis 3,
**dadurch gekennzeichnet,**
**dass** nach einer Belegung der ersten Oberfläche (14) mit Dotiermaterial ersten Leitungstyps in einem zusätzlichen Diffusionsschritt das Dotiermaterial von der ersten Oberfläche (14) aus in den Halbleiterkörper eindiffundiert wird und somit das Diffusionsgebiet (17) erzeugt wird.

5. Verfahren nach einem der vorhergehenden Ansprüche,
**dadurch gekennzeichnet,**
**dass** die erste Implantation derart durchgeführt wird, dass das Implantationsmaximum in lateraler Richtung von einem Kanalgebiet, das sich in dem Bodygebiet in vertikaler Richtung entlang der Gate-Elektrode erstreckt, zurückgesetzt angeordnet ist.

6. Verfahren nach Anspruch 5,
**dadurch gekennzeichnet,**
**dass** das Implantationsmaximum der ersten Implantation auch von der ersten Oberfläche zurückgesetzt angeordnet ist.

## Claims

1. Method for making a body region (9) of a first conduction type for a vertical MOS transistor device having a trench-shaped gate electrode in a vertical trench in a semiconductor body, comprising the following steps:
- producing a diffusion region (17) of the first conduction type in a semiconductor body between two of the trench-shaped gate electrodes at a first surface of the semiconductor body,
- first implantation of a doping material of the first conduction type (7) into the semiconductor body in such a way that the implantation maximum lies in the area of the diffusion region (17),
- second implantation of a doping material of the first conduction type (8) into the semiconductor body in such a way that the implantation maximum lies below the diffusion region (17),
- outdiffusion of the implanted doping material (7, 8) in such a way that a body region (9) is created with a less doped region (8), which extends in the direction of a drain region (2) towards a second surface (15) of the semiconductor body and is adjacent to a drift region (3).

2. Method according to claim 1,
**characterized in that**
the dose of the first implantation is higher than the dose of the second implantation by a factor 10 to 1000.

3. Method according to claim 2,
**characterized in that**
the dose of the first implantation is higher than the dose of the second implantation by a factor 100.

4. Method according to one of the claims 1 to 3,
**characterized in that**
after covering the first surface with doping material of the first conduction type in an additional diffusion step the doping material diffuses from the first surface (14) into the semiconductor body, thus creating the diffusion region (17).

5. Method according to one of the previous claims,
**characterized in that**
the first implantation is carried out in such a way that the implantation maximum in the lateral direction is arranged offset from a canal region, which extends in the body region in the vertical direction along the gate electrode.

6. Method according to claim 5,
**characterized in that**
the implantation maximum of the first implantation is also arranged offset from the first surface.

## Revendications

1. Méthode de fabrication d'une région de corps (9) d'un premier type conducteur pour un arrangement de transistors MOS vertical avec une électrode de grille en forme de tranchée dans une tranchée verticale dans un corps de semi-conducteur, comprenant les étapes suivantes :
- la production d'une zone de diffusion (17) du premier type conducteur dans le corps semi-conducteur entre deux des électrodes de grille en forme de tranchée au niveau d'une première surface du corps semi-conducteur,
- une première implantation d'un matériau dopant du premier type conducteur (7) dans le corps de semi-conducteur, de telle manière que le maximum d'implantation se trouve au niveau de la zone de diffusion (17),
- une seconde implantation d'un matériau dopant du premier type conducteur (8) dans le corps de semi-conducteur, de telle manière que le maximum d'implantation se trouve en-dessous de la zone de diffusion (17),
- une diffusion du matériau dopant (7, 8) implanté, de telle manière qu'une région de corps (9) soit créée avec une zone moins dopée (8) qui s'étend en direction d'une zone de drain (2) vers une seconde surface (15) du corps semi-conducteur et jouxte une région de migration (3).

2. Méthode selon la revendication 1,
**caractérisée en ce que**
la dose de la première implantation est plus élevée que la dose de la seconde implantation d'un facteur 10 à 1000.

3. Méthode selon la revendication 2,
**caractérisée en ce que**
la dose de la première implantation est plus élevée que la dose de la seconde implantation d'un facteur 100.

4. Méthode selon l'une des revendications 1 à 3,
**caractérisée en ce que**
après avoir recouvert la première surface (14) avec du matériau dopant du premier type conducteur dans une étape de diffusion supplémentaire le matériau dopant diffuse depuis la première surface (14) dans le corps semi-conducteur, créant ainsi la zone de diffusion (17).

5. Méthode selon l'une des revendications précédentes,
**caractérisée en ce que**
la première implantation est réalisée de telle manière que le maximum d'implantation dans la direction latérale est disposé en retrait d'une zone de canal qui s'étend dans la zone de corps dans la direction verticale le long de l'électrode grille.

6. Méthode selon la revendication 5,
**caractérisée en ce que**
le maximum d'implantation de la première implantation est également disposé en retrait de la première surface.
